# EUROPEAN PATENT APPLICATION

(11) **EP 4 851 712 A1**
(43) Date of publication of application: **09.12.2026**
(21) Application number: 25181019.8
(22) Date of filing: 05.06.2025
(51) Int. Cl.: G03F 1/84, G03F 7/20

(54) **A SUBSTRATE PATTERN IMAGING SYSTEM**

(71) Applicant: Mycronic AB, 183 03 Täby (SE)
(72) Inventor: Rådahl, Simon, 184 92 Åkersberga (SE); Walther, Jonas, 169 37 Solna (SE)
(74) Representative: AWA Sweden AB

(57) **Abstract**

A substrate pattern imaging system (100) is provided. The system (100) comprises a stage (110), a tool head (120); and an imaging source (607). The stage (110) comprises a support arrangement (140) configured to support a substrate (101). The arrangement (140) comprises a first support (141a) and a second support (141b); and a seesaw structure (142) which comprises a third support (141c) and a fourth support (141d), the seesaw structure (142) comprises a first element (142a) and a second element (142b), the first and second portions (142a, 142b) being connected via a joint element (143) being configured to allow rotational movement of the seesaw structure (142) in a third direction (D3).

## Description

### Technical field

The present disclosure generally relates to the field of patterned substrates and systems therefor. Specifically, it relates to a substrate pattern imaging system.

### Background art

Patterns in a micrometer or nanometer scale may be generated on substrates during the manufacture of photomasks, or to generate patterns directly onto a final substrate, so-called direct writing. In the production of semiconductor devices, a photomask is used as a master for mass production. Thus, the photomask acts as a template and is designed to transfer patterns onto wafers or other substrates in order to fabricate devices of all types.

During production of the photomask, the pattern generated on the photomask may comprise defects or impurities. If that is the case, the defects or impurities will be transferred to the substrates due to the photomask being the master or the template. Thus, defects or impurities on the mask may be replicated on the wafer. Such errors in production are very costly. It is therefore necessary to inspect or measure the photomasks to identify such errors.

During inspection of or measuring the photomasks, there is a need for the photomask to be arranged in a correct way such that the inspection or measuring may be performed correctly. Some present solutions use fixed supports configured to support the photomask during inspection or measuring, wherein the supports are arranged to support an edge of the photomask. A drawback with these solutions is that the fixed supports may not be able to support the photomask in an ideal way for an optimized inspection or measuring to be performed.

Therefore, there is a need to improve the support arrangement when supporting the photomask in substrate pattern imaging system, i.e. inspection systems and measuring systems.

### Summary

It is an object to mitigate, alleviate or eliminate one or more of the above-identified deficiencies in the art and disadvantages singly or in any combination and solve at least the above-mentioned problem.

According to a first aspect, there is provided a substrate pattern imaging system comprising:
a stage configured to support a substrate;
a tool head configured to focus an optical beam onto the substrate supported by the stage; and
an imaging source configured to capture image data based on light transmitted by and/or reflected by the substrate;
wherein the stage comprises a support arrangement configured to support the substrate, the support arrangement comprising:
   a first support and a second support being arranged at a first side of the support arrangement and being fixedly attached to the stage, wherein the first and second supports are spaced along a first direction and are configured to support a first and a second edge portion of the substrate, respectively; and
   a seesaw structure being arranged at a second side of the support arrangement, being opposite the first side, and being fixedly attached to the stage, and comprising a third support and a fourth support which are fixedly attached to the seesaw structure, wherein the third and fourth supports are spaced along the first direction and configured to support a third and a fourth edge portion of the substrate, respectively,
   wherein the seesaw structure comprises a first element and a second element, the first and second elements being connected via a joint element being configured to allow rotational movement of the seesaw structure in a third direction, being perpendicular to the first direction.

The substrate pattern imaging system may be a substrate pattern inspection system, or an inspection system. The inspection system may be configured to inspect a pattern on a substrate and/or the substrate. An inspection system may essentially be an automated microscope that images the substrate pattern and detect defects in the substrate pattern. The substrate pattern imaging system may be a substrate pattern measurement system, or measurement system. The measurement system may be configured to measure a pattern on a substrate. The measurement system may be configured to measure, and optionally evaluate, a position of the pattern on the substrate. Thus, the substrate pattern imaging system may be a system for measuring, inspecting or otherwise treating or evaluating a pattern on a substrate, or the substrate itself.

The substrate pattern imaging system may for example be a system arranged for inspecting and/or measuring a pattern created by a microlithography system or a nanolithography system. A nanolithography system may be capable of creating nanoscale patterns on a substrate, such patterns having features smaller than 100 nm.

The imaging source may be one or more line scan cameras. The imaging source may be configured to scan at least a portion of the substrate. The imaging source may allow to scan the substrate at higher speeds than a 2D camera.

The tool head may comprise optical components, such as lenses, mirrors, prisms, beam splitters, deflectors, modulators, etc., arranged and configured to focus an optical beam onto the substrate, or to collect and guide light from a target position on the substrate to an imaging, scanning or other recording sensor.

The stage and/or the tool head is movable to provide relative motion between the tool head and the stage along different axes. For example, the stage may be movable along a first axis and a third axis, or in a first and third directions, and the tool head may be movable along a second axis, or in a second direction. The substrate may be too large to be imaged or scanned all at once, so the substrate may need to be scanned or imaged bit by bit. Thus, having a stage which is movable along the first and third axes, it is possible to image larger substrates compared to if the stage would have been stationary along all axes. Further, having a tool head which is movable along the second axis is advantageous as it allows for focusing the optical beam onto the substrate. This may be advantageous as it allows for identifying possible defects in the substrate and/or impurities or dirt on the substrate. Preferably, the stage moves the substrate relative to the tool head in the first and third directions. Specifically, the first and third axes may be parallel with a surface of the substrate. The first axis may be perpendicular to the third axis. The first axis may be perpendicular to the second axis. The third axis may be perpendicular to the second axis.

In this context, the term "substrate" may be interpreted as a photomask. Preferably, photomasks, or substrates, consist of quartz substrates, coated with chrome and photoresist. Photomasks are manufactured by exposing the photoresist with a pattern and then developing and etching the plate to get a permanent pattern in the chrome layer. Once the photomask has been manufactured, it is important to ensure that the photomask meets certain requirements, for example the quality of the mask. In this context, it is preferred but not necessary, that once the photomask has been created, before it is loaded onto the substrate pattern imaging system, the photoresist is removed.

The substrate pattern imaging system is advantageous as it allows for being able to identify defects in the pattern of the substrate and/or impurities or dirt on the substrate in an accurate way. This is possible due to the imaging device being configured to capture image data based on light transmitted by and/or reflected by the substrate. By being able to identify defects or impurities prior to replicating the pattern on wafers, production costs may be kept lower compared to if the defects or impurities are not identified until after being replicated on the wafers. Preferably, the captured image data is compared with pattern data, for example computer aided designs (CAD).

The substrate may be loaded onto the support arrangement prior to starting scanning or imaging the substrate bit by bit. In this context, it is preferred but not necessary, that the supports are arranged to support a respective corner portion of the substrate. Thus, the edge portions may preferably be corner portions of the substrate.

The support arrangement is advantageous as it allows for supporting the substrate in a desired way. The support arrangement may support the substrate to be leveled and steady such that the optical beam may be properly focused on the substrate.

The support arrangement is further advantageous as it allows for supporting the substrate in a proper and desired way without being in contact with the pattern on the substrate. The support arrangement is a four-point support which is arranged to support the corner portions of the substrate, thereby avoid being in contact with the pattern of the substrate (i.e. the pattern is typically not provided in the corner portions of the substrate). Thus, with this design, it is possible to avoid adding any defects to the substrate when loading the substrate into the substrate pattern imaging system.

The support arrangement is yet further advantageous as it allows for keeping the deflection of the substrate as low as possible in order for the substrate pattern imaging system to function properly. The support arrangement is yet further advantageous as it allows for keeping the deflection of different substrates, loaded onto the support arrangement independently of each other, as similar as possible, wherein the different substrate may typically be of the same size. This is achieved due to the first and second supports together with the seesaw structure defining a plane without being over constrained. This is advantageous as it allows for loading different substrates onto the support arrangement without the need of measuring topography of each substrate. Instead, it is possible to measure one substrate and thereafter reuse the results for every substrate of the same type. Thus, a more efficient and less time-consuming arrangement is provided. Preferably, when the substrate is supported in the desired way, a maximum deflection may occur in the middle of the substrate. The seesaw structure is further advantageous as it allows for minimizing deflection variations between the substrates to avoid registration errors. If one of the four supports is located a little bit lower or higher than the other supports, the deflection of the mask may increase. The same phenomena may occur if the substrate surface facing the supports is not flat/level at the supports. Therefore, the support arrangement comprising the seesaw structure is advantageous since the seesaw structure is able to adjust the position of the substrate along the second axis such that the deflection may be kept as low as possible. It should however be noted that the third support and the fourth support is movable along the second axis, but in opposite direction along the second axis. This is achieved due to that the seesaw structure is allowed to provide the rotational movement around the third axis. It should also be noted that due to the movement along the second axis, there may be a small movement along the first and/or third axis as well, wherein the third support and the fourth support are movable in the opposite directions.

In this context, it is preferred but not necessary that the seesaw structure is a frictionless seesaw structure.

The seesaw structure is arranged for compensating for deflections of the substrate when the substrate is arranged at the support arrangement.

The first and second supports are fixed supports. The first and second supports may ensure that the substrate and seesaw structure do not tilt, or tilt as little as possible, once the substrate has been loaded onto the support arrangement, i.e. the four supports. In this context, it is preferred but not necessary, that the supports comprise a plate and a support element, typically a ball or the like. The plate may be attached to the stage or the seesaw structure, and the support element may be arranged to be in contact, and supporting, the substrate. The substrate may be supported by the support arrangement without fastening means or the like. Thus, preferably, there may be friction between the supports of the support arrangement, preferably the support elements, and the substrate to keep the substrate in position.

The connection element may be arranged for connecting the first element and the second element of the seesaw structure. The connection element may also allow the first and second elements to be movable in relation to each other. Thus, the connection element provides that the seesaw structure may function as a seesaw, i.e. being rotatable around the third axis. In this way, it is possible to compensate for the substrate being unbalanced or the like. Thus, the seesaw structure is advantageous as it allows for positioning the substrate at the support arrangement in a desired and beneficial way.

By way of example, the stage may be made of a stone material such as diabase. The interior of the stage, i.e. the portion of the stage to which the support arrangement is attached, may be made of a zero-expansion material such as Zerodur. This is advantageous as it allows for the substrate to be kept in position independently of, e.g., temperature variations. The seesaw structure may be made of a material comprising nickel, for example Invar. The supports may be made of stainless steel. The support may be made of a material which avoids damaging the substrate at the same time as it provides friction between the supports and the substrate.

According to some embodiments, the joint element is a flexure.

As readily appreciated by the skilled person, a flexure may be a mechanical component, or a combination of components, which is designed to bend or flex under load, without experiencing any permanent deformation or damages. The flexure is advantageous as it allows for precise movement or positioning of the seesaw structure.

The flexure is further advantageous as it does not provide, or at least substantially not provide, any friction when moving.

According to some embodiments, the joint element comprises a bearing.

The bearing may be any type of bearing that supports a load. By way of examples, the bearing may be ball bearing, plain bearing, air bearing (i.e. a biased air bearing) or magnetic bearing.

According to some embodiments, the joint element is arranged substantially at a midpoint of the seesaw structure.

This is advantageous as it allows for providing a well-balanced seesaw structure. This is further advantageous as it allows for distributing the load evenly between the two supports arranged at the seesaw structure.

According to some embodiments, the seesaw structure is arranged so as to define a pivot point substantially at the midpoint of the seesaw structure, wherein the seesaw structure is rotatable around the pivot point.

In this context, it is preferred but not necessary, that the pivot point is designed as the joint element.

It is preferred that the pivot point is arranged substantially at the midpoint of the seesaw structure to achieve a uniform load at the two supports (i.e. the third and fourth supports) and to keep the deflection of the substate as low as possible. With this design, in which the seesaw structure is arranged so as to define the pivot point substantially at the midpoint of the seesaw structure, it is possible to provide an even distribution of the substrate load on the third and fourth supports.

Thus, the support arrangement may be arranged to balance the substrate and to provide an even distribution of the substrate load on the supports.

According to some embodiments, the seesaw structure further comprises at least one first support element, arranged at a first end portion of the seesaw structure, and at least one second support element, arranged at a second end portion of the seesaw structure, being opposite the first end portion.

The first and second support elements may be arranged to connect the first and second elements of the seesaw structure. This is advantageous as it allows for limiting rotation of the seesaw structure around the wrong axis (i.e. along the first axis or the third axis) due to weight of the substrate but still allow rotation around the pivot point (i.e. along the second axis). This is further advantageous as it allows for controlling the rotation around the pivot point.

According to some embodiments, the at least one first and at least one second support elements are flexures.

According to some embodiments, the first support and the third support are spaced along a third direction.

According to some embodiments, the second support and the fourth support are spaced along the third direction.

According to some embodiments, the seesaw structure further comprises at least one stopping means being arranged at an end portion of the seesaw structure.

In this context, it is preferred but not necessary, that the seesaw structure comprises at least two stopping means being arranged at a respective end portion of the seesaw structure.

This may be advantageous as it allows for preventing over-rotation about the pivot point.

According to some embodiments, the support arrangement is configured to support a 6-inch substrate.

As readily appreciated by the skilled person, the support arrangement may be configured to support a substrate which is 6 inches long and 6 inches wide. The support arrangement may also be configured to support a smaller substrate being arranged with a frame or the like, wherein the frame has an outer perimeter corresponding to the shape of a 6-inch substrate.

According to some embodiments, the support arrangement is arranged in a through-hole of the stage.

This is advantageous as it allows for transmitting light through the substrate in an easy and efficient way. This is further advantageous as it allows for lenses being arranged at opposite side of the substrate to be able to be arranged as close as possible to the substrate. This provides that the size and weight of the lenses may be kept as low as possible.

It should however be noted that the support arrangement may be arranged at the stage (but not in a through-hole of the stage) if the substrate is made fully transparent.

According to some embodiments, the substrate pattern imaging system further comprising an illumination source configured to illuminate the substrate from a first side and a second side.

According to some embodiments, the substrate pattern imaging system further comprises a calibration substrate

The calibration substrate, or calibration mask, may be a portion of a substrate which is used for calibrating the substrate pattern imaging system. The calibration substrate is separated from the substrate supported by the support arrangement.

It is noted that other embodiments using all possible combinations of features recited in the above-described embodiments may be envisaged. Thus, the present disclosure also relates to all possible combinations of features mentioned herein.

### Brief description of the drawings

The disclosure will by way of example be described in more detail with reference to the appended schematic drawings, which show presently preferred embodiments of the invention.
Figure 1 is an illustration of a substrate pattern imaging system in accordance with the present disclosure.
Figure 2 is an illustration of a support arrangement in accordance with some embodiments.
Figure 3 is an illustration of a support arrangement in accordance with some embodiments.
Figure 4 is an illustration of a first deflection map when a substrate is loaded to a support arrangement.
Figure 5 is an illustration of a second deflection map when a substrate is loaded to a support arrangement.
Figure 6 is an illustration of a substrate pattern inspection system.
Figure 7 is an illustration of a substrate pattern measuring system.

As illustrated in the figures, the sizes of the elements and regions may be exaggerated for illustrative purposes and, thus, are provided to illustrate the general structures of the embodiments.

### Detailed description

The present invention will now be described more fully hereinafter with reference to the accompanying drawings, in which currently preferred embodiments of the invention are shown. The present invention may, however, be embodied in many different forms and should not be construed as limited to the embodiments set forth herein; rather, these embodiments are provided for thoroughness and completeness, and to fully convey the scope of the invention to the skilled addressee. Like reference characters refer to like elements throughout.

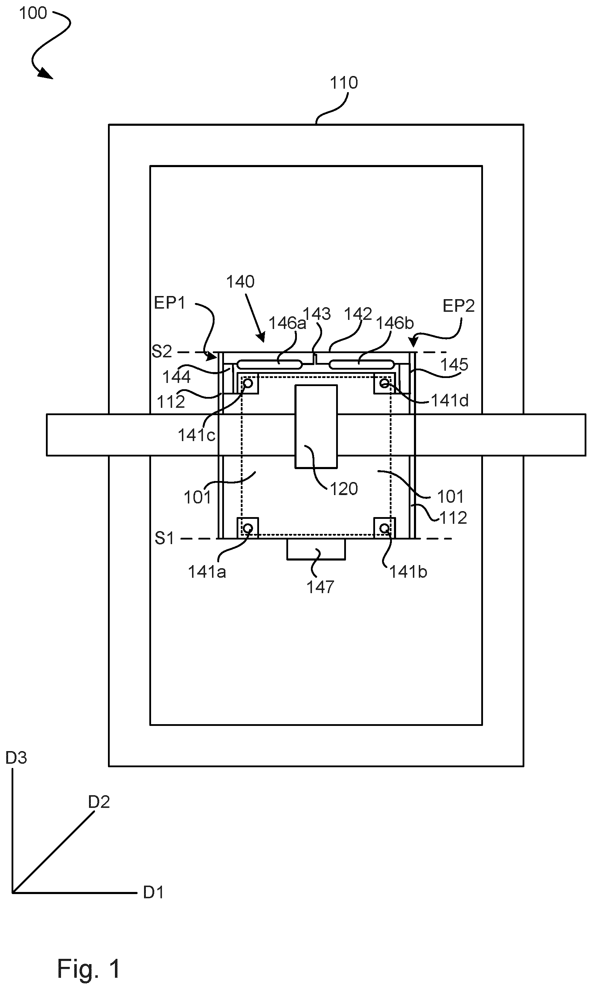

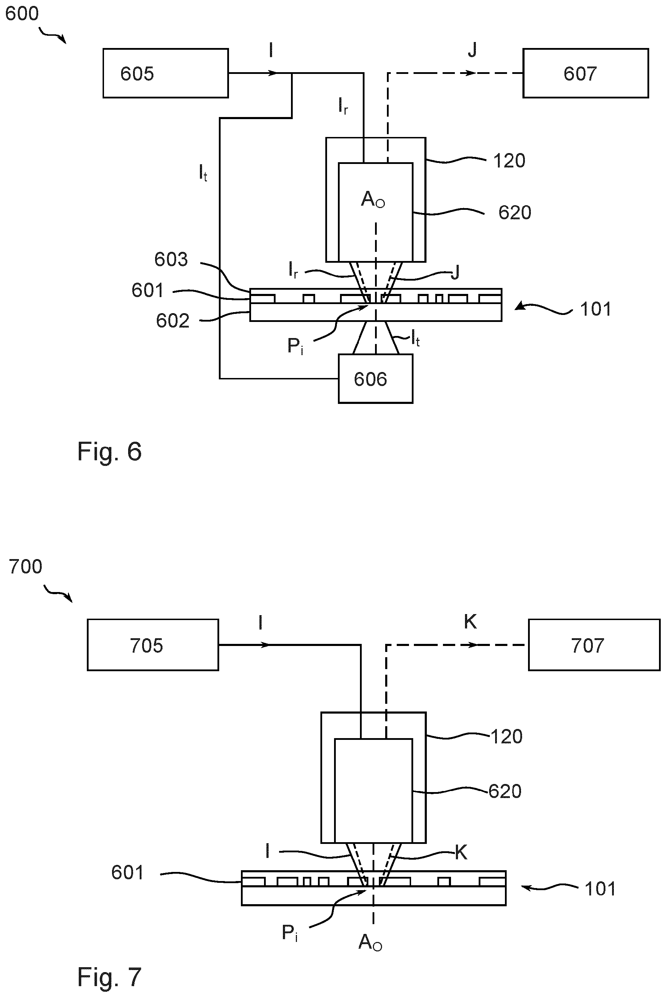

With reference to figure 1, a substrate pattern imaging system 100 is illustrated by way of example. Figure 1 illustrates a top view of the substrate pattern imaging system 100. In this context, it is preferred but not necessary, that the substrate pattern imaging system 100 is a substrate pattern inspection system 600 (illustrated and discussed in connection with figure 6) or a substrate pattern measuring system 700 (illustrated and discussed in connection with figure 7).

The substrate pattern imaging system 100 comprises a stage 110 configured to support a substrate 101, and a tool head 120 configured to focus an optical beam at the substrate 101. The substrate pattern imaging system 100 further comprises an imaging source 607 (illustrated and discussed in more detail in connection with figure 6), such as one or more line scan cameras. The imaging source 607 is configured to capture image data based on light transmitted by and/or reflected by the substrate 101. The image data may be used to identify defects or impurities of the substrate or to measure a quality of the substrate 101. This is advantageous as it allows for ensuring that the substrate 101 fulfils requirements before being used for mass production to fabricate different types of devices among other things.

The substrate 101 may comprise a plurality of layers. A carrier layer 602 may for example comprise a quartz or a glass substrate. A pattern layer may for example comprise a chrome and/or chrome oxide layer. A resist layer may comprise a photoresist layer. In this context, it is preferred but not necessary, that once the photomask has been created, before it is loaded onto the substrate pattern imaging system, the photoresist is removed. A pattern 601 may be generated on the substrate, and especially on the resist layer. Further, as indicated above, the substrate may in this context be interpreted as a photomask. Thus, during inspection of the substrate 101, the pattern 601 may be formed by the chrome and/or chrome oxide layer.

The substrate pattern imaging system 100 may, as indicated above, be configured to identify impurities on the substrate and/or errors in the pattern.

The stage 110 is movable in a first direction D1 and in a third direction D3, or along a first axis D1 and a third axis D3. The tool head 120 is carried by a carriage (not illustrated). The tool head 120 is movable in a second direction D2, or along a second axis D2. This is advantageous as it allows for focusing the optical beam at the substrate 101. Thus, the stage 110 moves the substrate 101 relative to the tool head 120 in the first and third directions D1, D3.

The stage 110 may comprise a through-hole 112 in which a support arrangement 140 may be arranged.

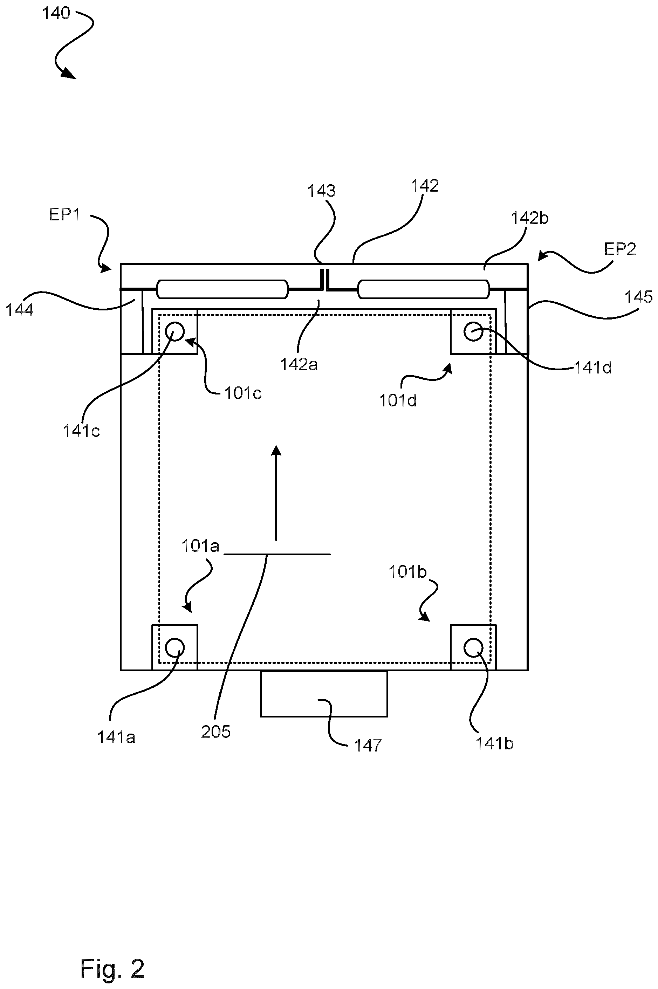

Figure 2 illustrates a first embodiment of the support arrangement 140. The support arrangement 140 is configured to support the substrate 101 in a desired way. In this context, it is preferred but not necessary, that the support arrangement 140 is arranged in the through-hole 112. This is advantageous as it providing illuminating light through the substrate 101. This is further advantageous as it allows for lenses of the tool head 120 (not illustrated), which are arranged on a respective side of the substrate 101, to be able to be as close as possible to the substrate 101. In this way, it is possible to keep the lenses smaller in both weight and size compared to if the lenses are arranged further away from the substrate 101.

The support arrangement 140 is a four-point support comprising a first support 141a, a second support 141b, a third support 141c and a fourth support 141d. The support arrangement is arranged for supporting edge portions 101a, 101b, 101c, 101d of the substrate 101, i.e., the four supports 141a, 141b, 141c, 14d are arranged for supporting a respective edge portion 101a, 101b, 101c, 101d of the substrate 101. As depicted in figures 1 and 2, the edge portions 101a, 101b, 101c, 101d are preferably corner portions of the substrate 101. As depicted in figures 1 and 2, the supports 141a, 141b, 141c, 141d may comprise a plate and a support element, typically a ball or the like. Each plate may be attached to the stage 110 or a seesaw structure 142, and the support element may be arranged to be in contact, and supporting, the substrate 101. In this context, it is preferred but not necessary, that the substrate 101 is only positioned at the support arrangement 140 without using any fastening means or the like. Thus, the substrate 101 may be kept in position by friction. However, it should be noted that other solutions may be used as well, such as with vacuum for suction the substrate 101 to the support arrangement 140. In this case, it may be possible to run the stage 110 with a higher speed compared to when the substrate 101 is kept in position by friction.

The first and second supports 141a, 141b are fixedly attached to the stage 110 at a first side S1 thereof. The first and second supports 141a, 141b may be fixedly attached to the stage 110 by fastening means, for example bolts or the like. The first and second supports 141a, 141b are spaced along the first direction D1. The first and second supports 141a, 141b may be oriented so that they are parallel with a long side of an imaging source image, for example a line scan camera image 205. Thus, the first and second supports 141a, 141b may be positioned along an elongation of for example the line scan camera image 205. In other words, the first and second supports 141a, 141b may for example be arranged along a line which is parallel with a long side of an imaging source image, for example a line scan camera image 205. This is advantageous as is allows for that the deflection of the substrate in this direction, i.e. in the first direction D1, is minimized. As is seen in Figure 1, the pixels of the line scan camera image 205 may be arranged along the first direction D1. Preferably, all pixels of the line scan camera image 205 are in focus at the same time. If the substrate 101 would rotate around the third direction D3 (for example when loading a new substrate 101 onto the support arrangement 140), one or more pixels may be out of focus. The first and second supports 141a, 141b provide that all substrates 101 loaded onto the support arrangement 140 may be arranged at the same angle around the third direction D3. In the third direction D3, the image generated by the imaging source 607 may be very thin and not as sensitive for plate deflection. The arrow depicted in figure 2 illustrates the scan direction of the imaging source 607.

The support arrangement 140 further comprises the seesaw structure 142 which is fixedly attached to the stage 110 at a second side S2 thereof, the second side being opposite the first side S1. The seesaw structure 142 extends along the second side S2. The seesaw structure 142 comprises a first element 142a and a second element 142b. The seesaw structure 142 may be fixedly attached to the stage 110 by fastening means, for example bolts or the like. The seesaw structure 142 comprises the third and fourth supports 141c, 141d, wherein the third and fourth supports 141c, 141d are fixedly attached to the seesaw structure 142. In this context, it is preferred but not necessary, that the third and fourth supports 141c, 141d are fixedly attached to the second element 142b of the seesaw structure 142.

The first and second elements 142a, 142b are connected via a joint element 143. The joint element 143 is arranged to allow movement of the seesaw structure 142 in the third direction D3. The joint element 143 is preferably arranged substantially at a midpoint of the seesaw structure 142. The seesaw structure 142 may be arranged so as to define a pivot point substantially at the midpoint of the seesaw structure 142, wherein the seesaw structure 142 is rotatable around the pivot point. In this way, the third and fourth supports 141a, 142b may be movable along the second axis D2, in opposite directions. It should be noted that, since the seesaw structure 142 may be rotatable around the pivot point, the third and fourth supports 141c, 141d may undergo a small movement in the first direction D1, or along the first axis D1, and in the third direction D3, or along the third axis D3, preferably in opposite directions along the third axis D3.

The joint element 143 may be a flexure. The joint element 143 may be a bearing such as a ball bearing, an air bearing, a plain bearing or a magnetic bearing. The joint element 143 may be designed to allow the seesaw structure 142 to rotate around the pivot point.

In this context, it is preferred but not necessary, that the first and second elements 142a, 142b are movable in relation to each other due to the joint element 143. In this context, it is preferred but not necessary, that the first element 142a is fixedly connected to the stage 110. The first and second elements 142a, 142b may be connected to a first support element 144 and a second support element 145 on a respective end portion EP1, EP2 of the seesaw structure 142. The first and second support elements 144, 145 may each be or comprise a flexure. The first and second support elements may be advantageous as it allows for limiting rotation of the seesaw structure 142 around the wrong axis (i.e. along the first axis D1 or the second axis D2) due to weight of the substrate 101 but still allow rotation around the pivot point (i.e. along the third axis D3). This is further advantageous as it allows for controlling the rotation around the pivot point.

The seesaw structure 142 comprises two stopping means 148, 149 being arranged at a respective end portion EP1, EP2, or adjacent to the respective end portion EP1, EP2, of the seesaw structure 142. It should however be noted that the seesaw structure 142 may comprise one stopping means or more than two stopping means. The stopping means may be advantageous as it allows for preventing over-rotation of the seesaw structure 142.

In this context, it is preferred, but not necessary, that the support arrangement 140 is arranged substantially in the middle of the stage 110. In this way, it is possible to image the substrate 101 in an easy and efficient way. It is also possible to allow the optical beam to reach the complete substrate 101 as well as a calibration substrate 147, or calibration mask, which is arranged at the stage 110, adjacent to the substrate 101. It should however be noted that the substrate 101 and the calibration substrate 147 may be arranged anywhere at the stage 110, as long as the optical beam is able to reach the substrate 101 and the calibration substrate 147.

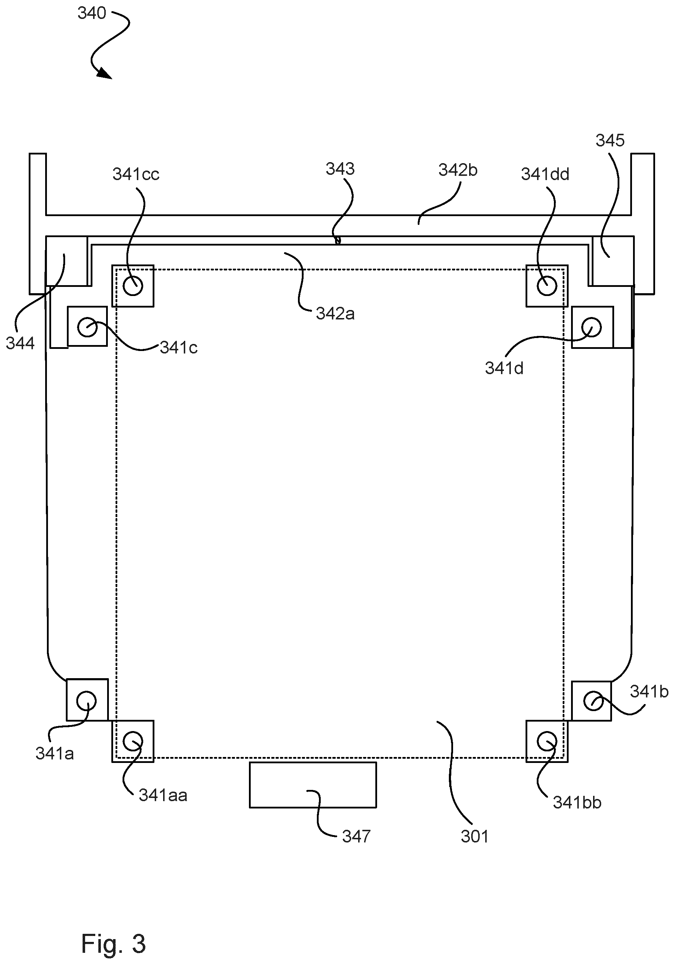

With reference to figure 3, a second embodiment of a support arrangement 340 is illustrated by way of example. Further to the features illustrated and discussed in connection with figures 1 and 2, the second embodiment of the support arrangement 340 comprises four additional supports 341aa, 341bb, 341cc, 341dd. Thus, the support arrangement 340 comprises eight supports 341a, 341aa, 341b, 341bb, 341c, 341cc, 341d, 341dd.

The supports 341a, 341b, 341c, 341d are similar to the supports 141a, 141b, 141c, 141d which have been discussed in connection with figures 1 and 2. Thus, the supports 341a, 341b, 341c, 341d form a four-point support configured to support the substrate 301. In this context, it is preferred but not necessary, that the supports 341a, 341b, 341c, 341d are arranged to support a 6-inch substrate 301. The supports 341aa, 341bb, 341cc, 341dd form a four-point support configured to support a substrate 301 of a different size than substrate that the supports 341a, 341b, 341c, 341d are configured to support. In this context, it is preferred but not necessary, that the supports 341aa, 341bb, 341cc, 341dd are configured to support a 5-inch substrate 301. The supports 341a, 341aa, 341b, 341bb may be fixedly attached to the stage 110 at the first side S1 thereof. The support 341a, 341b are spaced along the first direction D1. The supports 341aa, 341bb are spaced along the first direction D1. The supports 341a, 341b are displaced in relation to the supports 341aa, 341bb as seen along the third direction D3.

The support arrangement 340 further comprises a seesaw structure 342 similar to the seesaw structure 142 discussed in connection with figures 1 and 2. The seesaw structure 342 may be movably attached to the stage 110 at the second side S2 thereof. This is advantageous as it allows for moving the seesaw structure 342 between different positions along the third direction D3 depending on the size of the substrate 301. The seesaw structure 342 comprises the supports 341c, 341cc, 341d, 341dd which are fixedly attached to the seesaw structure 342. The support 341c, 341d are spaced along the first direction D1. The supports 341cc, 341dd are spaced along the first direction D1. The supports 341c, 341d are displaced in relation to the supports 341cc, 341dd as seen along the third direction D3.

The second embodiment of the seesaw structure 340 as illustrated in figure 3, typically comprises a first position and a second state. The first position is arranged for supporting a larger substrate, i.e. a 6-inches substrate, and the second position is arranged for supporting a smaller substrate, i.e. a 5-inches substrate. In the first position, the seesaw structure 342 is arranged further from the first and second supports 341a, 341b, along the first direction D1, such that a larger substrate 301 may be supported by the supports 341a, 341b, 341c, 341d. In the second position, as depicted in figure 3, the seesaw structure 342 is arranged closer to the first and second supports 341a, 341b, along the first direction D1, such that a smaller substrate 301 may be supported by the support 341aa, 341bb, 341cc, 341dd.

Further to the eight supports 341a, 341aa, 341b, 341bb, 341c, 341cc, 341d, 341dd, the support arrangement 340 comprises the same features as illustrated and discussed in connection with figures 1 and 2. Thus, the support arrangement 340 comprises the seesaw structure 342 comprising the first and second elements 342a, 342b, the connection element 343, the first and second support elements 344, 345, the calibration substrate 347 and the stopping means 348, 349.

Effects and features of the support arrangement 340 of the second embodiment are largely analogous to those illustrated and described in connection with the support arrangement 140 of the first embodiment illustrated and discussed in connection to figures 1 and 2

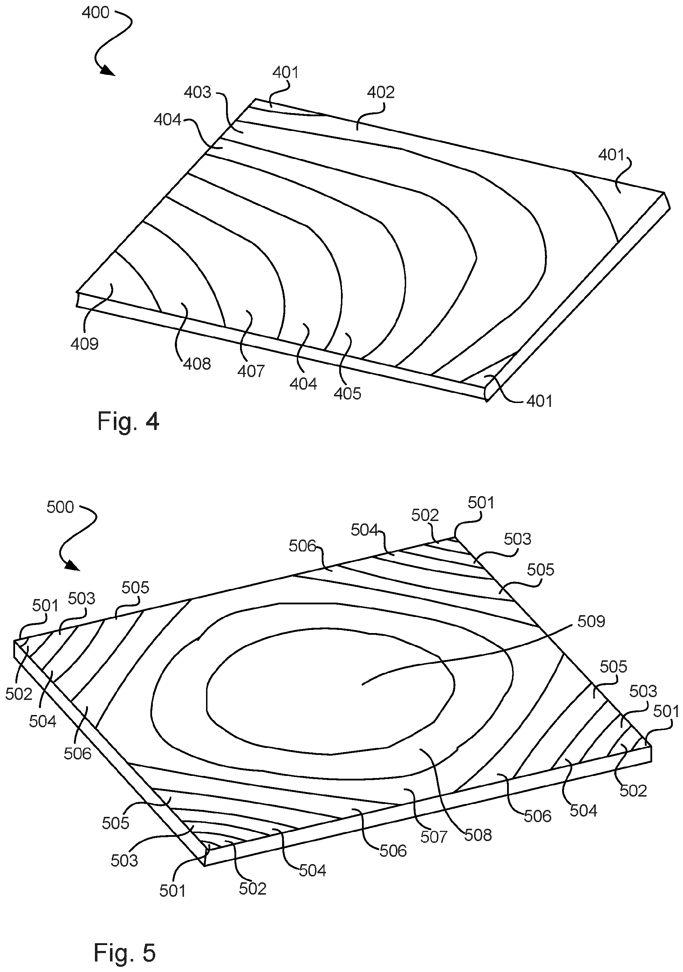

With reference to figure 4, a deflection map 400 of a four-point support. The deflection map 400 illustrates a deflection resulting from supporting a substrate 101 by four supports, wherein one of the supports is located a little bit higher or lower than the other three is illustrated by way of example. The deflection map 400 comprises different portions 401, 402, 403, 404, 405, 406, 407, 408, 409 illustrating different magnitude of the deflection of the substrate 101 once loaded onto the support arrangement 140, 340.

When one of the supports is located a little bit higher or lower than the other three supports, the deflection of the substrate may increase, which is illustrated in figure 4. The same phenomenon may occur if the substrate surface facing the supports is not flat/level at the supports. In figure 4, one of the supports are located 4 µm below the others causing the deflection of the substrate 101 to be around 4 µm.

With the present disclosure, and especially with the seesaw structure 142, 342, the risk of having one support being located a little bit higher or lower than the other three supports may be reduced and thus, the deflection of the substrate may be able to be kept as low as possible. This is discussed in connection with figure 5. One reason for having a non-flat substrate 101 supported by the support arrangement may be that a surface of the substrate 101 may be uneven such that one or more portions, i.e. edge portions, of the substrate 101 mya be arranged higher than the others.

With reference to figure 5, a deflection map 500 of a four-point support as discussed in connection with figures 1-3 is illustrated by way of example. The deflection map 500 illustrates a deflection resulting from supporting the substrate 101 as illustrated in figures 1-3, i.e. supporting the substrate 101 by the support arrangement 140, 340. The deflection map 500 comprises different portions 501, 502, 503, 504, 505, 506, 507, 508, 509 illustrating different magnitude of the deflection of the substrate 101 once loaded onto the support arrangement 140, 340. The portion 501 defines the smallest deflection and the portion 509 illustrates the maximum deflection, i.e. the maximum deflection is in the middle of the substrate 101 and is about 1 µm.

With this design, in which the support arrangement 140, 240 comprises the seesaw structure 142, 342, it is possible to provide an even distribution of the substrate load on the supports 141a, 141b, 141c, 142d even if the substrate 101 may have an uneven surface as described in connection with figure 4.

With the present disclosure, it is possible to keep the deflection of different substrates loaded onto the support arrangement independently of each other as similar as possible, wherein the different substrate may typically be of the same size. This is achieved due to that the first and second supports together with the seesaw structure define a plane without being over constrained. This is advantageous as it allows for loading different substrates onto the support arrangement without the need of measuring topography of each substrate. Instead, it is possible to measuring one substrate and thereafter reuse the results for every substrate of the same type.

Figures 6 and 7 schematically illustrate the substrate pattern imaging system 100 in more detail. In figure 6, the substrate pattern imaging system 100 is illustrated as an inspection system 600, or a substrate pattern inspection system. In figure 7, the substrate pattern imaging system 100 is illustrated as a measurement system 700, or a substrate pattern measurement system. As depicted in figures 6 and 7, the substrate 101 may be provided with a cover layer 603, such as a pellicle, to prevent contamination of the pattern 601 on the substrate 101. The pellicle may comprise a frame, preferably made of aluminum, being provided with a film to prevent impurities and dirt interfering with the pattern 601 on the substrate 101. The pellicle may be substantially the same width as the substrate 101.

The inspection device 600 is configured to generate highly detailed images of a pattern 601 on the substrate 101, to allow for inspection of the pattern. An inspection system 600 may be configured to compare how well the pattern 601 on the substrate 101 corresponds to the original pattern data. Furthermore, the inspection system 600 may be configured to detect contamination or impurities of the substrate 101, or errors in the pattern 601.

The inspection system 600 comprises an illumination source 605, configured to provide illumination light I. The illumination source 605 is configured to illuminate the substrate 101 from a first side and a second, opposite, side. In Figure 6, the illumination light l is divided into reflection light Ir and transmission light It. The reflection light Ir is guided to the tool head 120, where it is focused onto the first side of the substrate 101 by an objective lens 620. The transmission light It is guided to an illumination unit 606, where it is focused onto the second side of the substrate 101.

The inspection system 600 further comprises the imaging source 607 as previously discussed in connection with figure 1. The tool head 120 is configured to transmit light J, gathered by the objective lens 620 at a point of interest Pi on the substrate 101, to the imaging source 607 as the tool head 120 is moved relative to the substrate 101. In other words, the imaging source 607 is configured to scan the substrate 101 through the objective lens 620. The carrier layer 602 and the cover layer 603 may be light-transmissive, while the pattern 601 may be reflective. Thus, some of the reflection light Ir may be reflected by the pattern 601 toward the tool head 120. The reflected reflection light may be gathered by the objective lens 620 and detected by the imaging source 607 as a first representation of the pattern 601 on the substrate 101. Simultaneously, or separately, the illumination unit 606 may illuminate the second surface of the substrate 101 with the transmission light It. Some of the transmission light It is reflected by the pattern 601, while other transmission light It is transmitted through the carrier layer 602 and the cover layer 603, toward the tool head 120. The transmitted transmission light may be gathered by the objective lens 620 and detected by the imaging source 607 as a second representation of the pattern 601 on the substrate 101. Thus, the light J gathered by the objective lens 620 at the point of interest Pi may comprise reflection light Ir reflected by the pattern 601 and/or transmission light It transmitted by the substrate 101.

The inspection system 600 may further comprise a processor (not depicted) configured to detect errors, defects, or contaminations of the pattern 601 or on the substrate 101 based on a scan of the substrate 101 detected or generated by the imaging source 607 and a position of the tool head 120 in relation to the substrate 101 during said scan.

When working in micro- or nanoscale, the precise positioning of the pattern 601 on the substrate 101 is a crucial quality measure. As previously mentioned, substrates may be used to mass produce semiconductor devices. An error in the position of the pattern 601 on the substrate 101 may result in corresponding errors in the semiconductor devices manufactured using the photomask.

To verify the positioning of the pattern 601 on the substrate 101, the substrate pattern measurement system 700 may be used, as depicted in figure 7. The measurement system 700 comprises an illumination source 705, configured to provide illumination light I. The illumination light l is guided to the tool head 120 and focused onto a point of interest Pi on the substrate 101. At least some of the illumination light K is reflected toward the tool head 120 and transmitted to an imaging unit 707. The imaging unit 707 is configured to capture an image of a portion of the substrate 101 through the objective lens 620.

The measurement system 700 may further comprise a processor (not depicted) configured to detect a reference mark on the substrate 101 in the image captured by the imaging unit 707. The processor may further determine a position of the reference mark on the substrate 101 based on a position of the reference mark in the image, and a position of the tool head 120 relative to the substrate 101 at the time of capture of the image.

The person skilled in the art realizes that the present invention by no means is limited to the preferred embodiments described above. On the contrary, many modifications and variations are possible within the scope of the appended claims.

For example, the support structure 140 described above with reference to figures 1 and 2, may be implemented in the inspection system 600 as described above with reference to figure 6. The support structure 140 described above with reference to figures 1 and 2, may be implemented in the measuring system 700 as described with reference to figure 7. The support structure 340 described above with reference to figure 3 may be implemented in the substrate pattern imaging system 100 as described above with reference to figure 1. The support structure 340 described above with reference to figure 3, may be implemented in the inspection system 600 as described above with reference to figure 6. The support structure 340 described above with reference to figure 3, may be implemented in the measuring system 700 as described with reference to figure 7.

Although features and elements are described above in particular combinations, each feature or element can be used alone without the other features and elements or in various combinations with or without other features and elements.

Additionally, variations to the disclosed embodiments can be understood and effected by the skilled person in practicing the claimed invention, from a study of the drawings, the disclosure, and the appended claims. In the claims, the word "comprising" does not exclude other elements, and the indefinite article "a" or "an" does not exclude a plurality. The mere fact that certain features are recited in mutually different dependent claims does not indicate that a combination of these features cannot be used to advantage.

## Claims

1. A substrate pattern imaging system (100) comprising:
a stage (110) configured to support a substrate (101);
a tool head (120) configured to focus an optical beam onto the substrate (101) supported by the stage (110); and
an imaging source (607) configured to capture image data based on light transmitted by and/or reflected by the substrate (101);
wherein the stage (110) comprises a support arrangement (140) configured to support the substrate (101), the support arrangement (140) comprising:
a first support (141a) and a second support (141b) being arranged at a first side (S1) of the support arrangement (140) and being fixedly attached to the stage (110), wherein the first and second supports (141a, 141b) are spaced along a first direction (D1) and are configured to support a first and a second edge portion (101a, 101b) of the substrate (101), respectively; and
a seesaw structure (142) being arranged at a second side (S2) of the support arrangement (140), being opposite the first side (S1), and being fixedly attached to the stage (140), and comprising a third support (141c) and a fourth support (141d) which are fixedly attached to the seesaw structure (142), wherein the third and fourth supports (141c, 141d) are spaced along the first direction (D1) and configured to support a third and a fourth edge portion (101c, 101d) of the substrate (101), respectively,
wherein the seesaw structure (142) comprises a first element (142a) and a second element (142b), the first and second elements (142a, 142b) being connected via a joint element (143) being configured to allow rotational movement of the seesaw structure (142) in a third direction (D3), being perpendicular to the first direction (D1).

2. The substrate pattern imaging system (100) according to claim 1, wherein the joint element (143) is a flexure.

3. The substrate pattern imaging system (100) according to claim 1, wherein the joint element (143) comprises a bearing.

4. The substrate pattern imaging system (100) according to any one of the preceding claims, wherein the joint element (143) is arranged substantially at a midpoint of the seesaw structure (142).

5. The substrate pattern imaging system (100) according to any one of the preceding claims, wherein the seesaw structure (142) is arranged so as to define a pivot point substantially at the midpoint of the seesaw structure (142), wherein the seesaw structure (142) is rotatable around the pivot point.

6. The substrate pattern imaging system (100) according to any one of the preceding claims, wherein the seesaw structure (142) further comprises at least one first support element (144), arranged at a first end portion (EP1) of the seesaw structure (142), and at least one second support element (145), arranged at a second end portion (EP2) of the seesaw structure (142), being opposite the first end portion (EP1).

7. The substrate pattern imaging system (100) according to claim 5, wherein the at least one first and at least one second support elements (144, 145) are flexures.

8. The substrate pattern imaging system (100) according to any one of the preceding claims, wherein the first support (141a) and the third support (141c) are spaced along the third direction (D3).

9. The substrate pattern imaging system (100) according to any one of the preceding claims, wherein the second support (141b) and the fourth support (141d) are spaced along the third direction (D3).

10. The substrate pattern imaging system (100) according to any one of the preceding claims, wherein the seesaw structure (142) further comprises at least one stopping means (148, 149) being arranged at an end portion of the seesaw structure.

11. The substrate pattern imaging system (100) according to any one of the preceding claims, wherein the support arrangement (140) is configured to support a 6-inches substrate.

12. The substrate pattern imaging system (100) according to any one of the preceding claims, wherein the support arrangement (140) is arranged in an through-hole of the stage (110).

13. The substrate pattern imaging system (100) according to any one of the preceding claims, further comprising an illumination source (605) configured to illuminate the substrate (101) from a first side (201a) and a second side (201b).

14. The substrate pattern imaging system (100) according to any one of the preceding claims, further comprising a calibration substrate (147).
